# EUROPEAN PATENT APPLICATION

(11) **EP 4 465 800 A1**
(43) Date of publication of application: **20.11.2024**
(21) Application number: 24160442.0
(22) Date of filing: 29.02.2024
(51) Int. Cl.: H10K 59/80, H10K 59/126, H10K 50/86

(54) **LIGHT EMITTING ELEMENT**

(30) Priority: 16.05.2023 CN 202310570695
(71) Applicant: Taizhou Guanyu Technology Co., Ltd., Taizhou City, Zhejiang Province (CN)
(72) Inventor: HU, Gengshuo, Taizhou City (CN); CHANG, Yu-Lung, 710032 Tainan City (TW); CHEN, Huei-Siou, 103 Taipei City (TW); HSU, Kuo-Cheng, 406 Taichung City (TW)
(74) Representative: Michalski Hüttermann & Partner Patentanwälte mbB

(57) **Abstract**

The present disclosure provides a light emitting element including a substrate (100), a plurality of light blocking layers (101), a cover layer (102), a plurality of protrusions (105) and an anti-reflective layer (108). The light blocking layers are disposed on a first surface (100s1) of the substrate and include a plurality of openings. The plurality of protrusions are disposed on the cover layer, and two adjacent protrusions of the plurality of protrusions have an organic light emitting unit in between. The anti-reflective layer is disposed on a second surface (100s2) of the substrate. The second surface is parallel to and opposite to the first surface.

## Description

### BACKGROUND OF THE PRESENT DISCLOSURE

### FIELD OF THE PRESENT DISCLOSURE

The present disclosure relates to a light emitting element, and more particularly to an organic light emitting element.

### DESCRIPTION OF THE PRIOR ART

Organic light emitting devices are extensively used in the highest-end electronic devices. However, due to limitations of current techniques, light emitting effects of organic light emitting devices cannot be effectively controlled, in a way that severe ghosting and optical crosstalk are likely produced and that optical effects of the organic light emitting devices may not be as good as expected. Organic light emitting devices are used in various applications, for example, automotive head-up displays (HUDs), smart glasses, telescope devices and scope device. If halos generated by organic light emitting devices are not effectively controlled, the feasibility of the applications above is greatly reduced. The present disclosure provides a device for overcoming the dilemma above.

### SUMMARY OF THE PRESENT DISCLOSURE

The present disclosure provides a light emitting element including a substrate, a plurality of light blocking layers, a cover layer, a plurality of protrusions and an anti-reflective layer. The light blocking layers are disposed on a first surface of the substrate and include a plurality of openings. The plurality of protrusions are disposed on the cover layer, and two adjacent protrusions of the plurality of protrusions have an organic light emitting unit in between. The anti-reflective layer is disposed on a second surface of the substrate. The second surface is parallel to and opposite to the first surface.

In some embodiments, an average reflectance of the anti-reflective layer is smaller than a first value, and a reflectance of the anti-reflective layer with respect to a predetermined wavelength is smaller than a second value, wherein the first value is smaller than the second value.

In some embodiments, the predetermined wavelength includes a wavelength of visible light.

In some embodiments, the organic light emitting unit includes a first light emitting unit and a second light emitting unit, wherein each of the first light emitting unit and the second light emitting unit has an organic light emitting stack layer including an organic material.

In some embodiments, each of the first light emitting unit and the second light emitting unit has an effective light emitting region with a size defined by an anode located below each of the light emitting units.

In some embodiments, the light blocking layers are electrically insulated from a conductive layer disposed on the cover layer via the cover layer.

In some embodiments, the substrate includes a transparent material.

In some embodiments, an edge of one of the plurality of openings of the light blocking layers is unaligned with an edge of one of the plurality of protrusions.

The present disclosure provides a light emitting element including a substrate, an anti-reflective layer, a plurality of light blocking layers, a cover layer, a conductive layer and a plurality of protrusions. The anti-reflective layer is below the substrate and is in contact with the substrate. The plurality of light blocking layers are over the substrate and are in contact with the substrate. The cover layer is over the substrate and covers the plurality of light blocking layers. The conductive layer is over the cover layer. The plurality of protrusions are disposed over a portion of the conductive layer.

In some embodiments, a reflectance of the anti-reflective layer is smaller than a first value, and a reflectance of the anti-reflective layer with respect to a wavelength of visible light is smaller than a second value, wherein the first value is smaller than the second value.

In some embodiments, the first value is smaller than 0.6%, and the second value is smaller than 1%.

In some embodiments, the conductive layer includes an anode.

In some embodiments, in a vertical direction, each of the plurality of protrusions has an edge, which is offset from an edge of one of the plurality of light blocking layers.

In some embodiments, an area of each of the plurality of light blocking layers in a horizontal direction is greater than an area of each of the plurality of protrusions.

### BRIEF DESCRIPTION OF THE DRAWINGS

FIG. 1 is a schematic diagram of an application scenario of a light emitting element according to an embodiment;
FIG. 2 is a plan view of an example of an intermediate product of a light emitting element;
FIG. 3 is a cross-sectional diagram of an example taken along the line AA in FIG. 2;
FIG. 4A to FIG. 4G depict different stages of a process for manufacturing a light emitting element according to an embodiment;
FIG. 5A and FIG. 5B are plan views of a light blocking layer according to an embodiment; and
FIG. 6 is a flowchart of manufacturing of a light emitting element according to an embodiment.

### DETAILED DESCRIPTION OF THE EMBODIMENTS

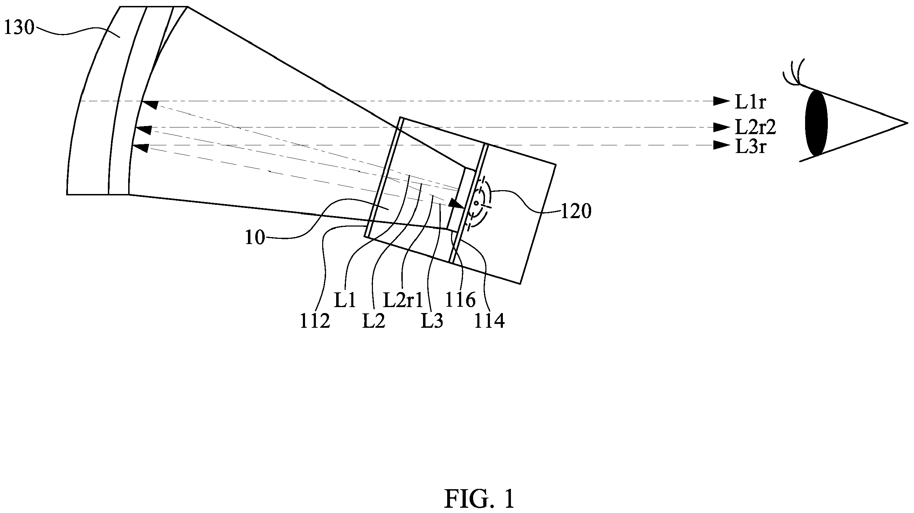

FIG. 1 shows a schematic diagram of an application scenario of a light emitting element 10 according to an embodiment. The light emitting element 10 includes a first element 112 and a second element 114. The first element 112 can include a glass material, and the second element 114 can include an organic light emitting material. The light emitting element 10 can form a bullseye pattern 120 on a spectrometer 130, for the human eye to identify the bullseye pattern 120.

In some embodiments, a light L1 emitted by the light emitting element 10 travels to the spectrometer 130 through the first element 112, and is reflected by the spectrometer 130 to become a light L1r visible to the human eye. As shown in FIG. 1, the light L1 is not reflected while passing through the first element 112. In some embodiments, a light L2 emitted by the light emitting element 10 is partially reflected while passing through the first element 112 and forms a light L2r1. The remaining portion of the light L2 that is not reflected travels to the spectrometer 130, and is reflected by the spectrometer 130 to become a light L2r2 visible to the human eye. The human eye observes the bullseye pattern 120 with the light L1r or the light L2r2, thereby forming an effective field of view (FOV). In some embodiments, the light L2r1 is also reflected to form a light L3, which travels to the spectrometer 130 through the first element 112 and is reflected by the spectrometer 130 to become a light L3r visible to the human eye. Since the light L3r received by the human eye generates interference on the light L1r or the light L2r2 to cause an issue such as ghosting or optical crosstalk, the optical effect of the light emitting element 10 is not as good as expected.

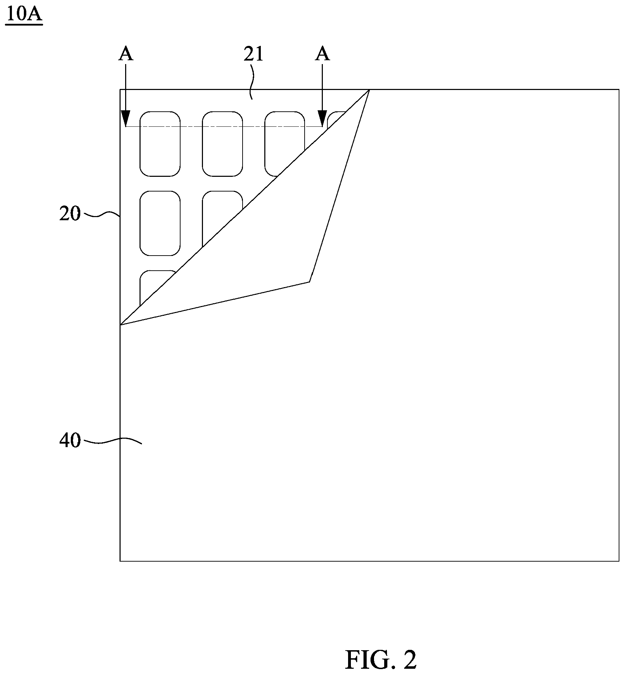

FIG. 2 shows a plan view of an example of an intermediate product of a light emitting element 10A. The light emitting element 10A includes a light emitting layer 20, and a cover layer 40 located over the light emitting layer 20. For the light emitting layer 20, a spacer 21 can be designed to provide a recess array used to accommodate a light emitting pixel array. In some embodiments, the spacer 21 can include a photosensitive material.

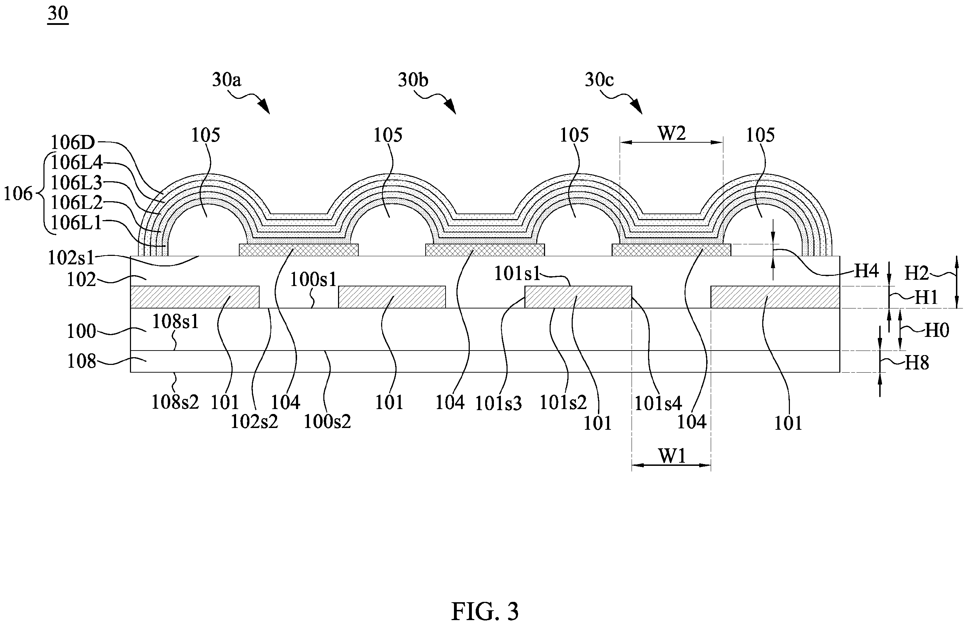

FIG. 3 shows a cross-sectional diagram of an example taken along the line AA in FIG. 2 and illustrates only a light emitting region. For brevity and clarity, the cover layer 40 is omitted. In some embodiments, a light emitting element 30 includes a substrate 100, a plurality of light blocking layers 101, a cover layer 102, a plurality of first electrodes 104, a plurality of protrusions 105, an organic light emitting stack layer 106, a second electrode 106D and an anti-reflective layer 108. In some embodiments, the organic light emitting stack layer 106 includes a carrier injection layer 106L1, a carrier transport layer 106L2, an organic emissive layer 106L3, and an organic carrier transport layer 106L4. In some embodiments, the light emitting element 30 includes a first organic light emitting unit 30a, a second organic light emitting unit 30b and a third organic light emitting unit 30c.

In some embodiments, the substrate 100 can include a thin-film transistor (TFT) array. In some embodiments, the substrate 100 includes a base material (not shown), a dielectric layer (not shown), and one or more circuits (not shown) disposed on the base material or in the base material. In some embodiments, the base material is transparent, or is at least partially transparent. In some embodiments, the base material is not flexible, and a material of such base material can include glass, quartz, low-temperature polysilicon (LTPS) or other appropriate materials. In some embodiments, the base material is flexible, and a material of such base material can include transparent epoxy resin, polyimide, polyvinyl chloride, methyl methacrylate or other appropriate materials. The dielectric layer is disposed on the base material as needed. In some embodiments, the dielectric layer can include silicon oxide, silicon nitride, silicon oxynitride, or other appropriate materials.

In some embodiments, the circuit can include a complementary metal- oxide-semiconductor (CMOS) circuit, or multiple transistors and multiple capacitors adjacent to the transistors, wherein the transistors and the capacitors are formed on the dielectric layer. In some embodiments, each of the transistors is a thin-film transistor (TFT). Each of the transistors includes a source/drain region (including at least one source region and one drain region), a channel region located in the source/drain region, a gate electrode disposed above the channel region, and a gate insulator located between the channel region and the gate electrode. The channel region of the transistor can be made of a semiconductor material, for example, silicon or other elements selected from group IV or group III and group V.

The anti-reflective layer 108 is located below the substrate 100. The substrate 100 can be in direct contact with an upper surface 108s1 of the anti-reflective layer 108. The substrate 100 is not in contact with a lower surface 108s2 of the anti-reflective layer 108. The anti-reflective layer 108 can be disposed on a lower surface 100s2 of the substrate 100. The lower surface 100s2 of the substrate 100 is parallel to and opposite to an upper surface 100s1 of the substrate 100. A thickness H8 of the anti-reflective layer 108 is less than a thickness H0 of the substrate 100. In some embodiments, the anti-reflective layer 108 includes an anti-reflective coating (ARC) so as to reduce the reflectance of light and to increase a transmittance of light. When secondary reflection of light is produced on the ARC, the original reflected light is interfered to thus reduce the reflected light. The anti-reflective layer 108 can include, for example but not limited to, calcium fluoride, magnesium fluoride, titanium oxide, lead sulfide, lead selenide, a vinyl silsesquioxane hybrid film, or a diamond film. In some embodiments, the anti-reflective layer 108 includes a layer of a single material. In some embodiments, the anti-reflective layer 108 includes a composite layer formed of a plurality of materials. In some embodiments, the anti-reflective layer 108 includes an organic material. In some embodiments, the anti-reflective layer 108 includes an inorganic material.

In some embodiments, an average reflectance of the anti-reflective layer 108 for all wavelengths is smaller than a first value. In some embodiments, a reflectance of the anti-reflective layer 108 for a predetermined wavelength is smaller than a second value, wherein the predetermined wavelength includes the wavelength of visible light. In some embodiments, the first value is smaller than the second value. The first value is smaller than 0.6%, and the second value is smaller than 1%. In some embodiments, the first value is greater than or equal to the second value. In some embodiments, the predetermined wavelength is within a range between about 420 nm and about 680 nm. In some embodiments, the predetermined wavelength is within a range between about 380 nm and about 780 nm.

The anti-reflective layer 108 can reduce reflected light that travels downward from the substrate 100. Under a predetermined wavelength, light reflected by the upper surface 108s1 of the anti-reflective layer 108 and light reflected by the lower surface 108s2 of the anti-reflective layer 108 are counteracted, leading to an extremely low reflected energy. Considering that incident energy is equal to reflected energy plus transmitted energy, the transmitted energy is correspondingly enhanced. Thus, the anti-reflective layer 108 can also be referred to as an antiglare or anti-reflection coating.

Light that travels downward from the substrate 100 comes into contact with the anti-reflective layer 10, and continues traveling downward and is propagated outward. In other words, light that travels downward from the substrate 100 comes into contact with the anti-reflective layer 108 and is not reflected at all or is reflected minimally, so that ghosting and optical crosstalk caused to other light can be reduced to render a clear image. Referring to the embodiment in FIG. 1, the anti-reflective layer 108 can be disposed at the first element 112 so as to absorb the reflected light L2r1 of the light L2, thereby significantly reducing the light L3 and the light L3r to prevent from causing ghosting and optical crosstalk to the other lights L1r and L2r2. Thus, the anti-reflective layer 108 can increase contrast of the light emitting units as well as enhancing optical effects of the light emitting element 30.

The plurality of light blocking layers 101 are formed on the substrate 100. The plurality of light blocking layers 101 are in direct contact with the upper surface 100s1 of the substrate 100. The plurality of light blocking layers 101 are separated from one another by a distance W1. A thickness H1 of the light blocking layers 101 is smaller than the thickness H0 of the substrate 100. The thickness H1 of the light blocking layers 101 can be substantially equal to the thickness H8 of the anti-reflective layer 108. The thickness H1 of the light blocking layers 101 can be smaller than the thickness H8 of the anti-reflective layer 108. The thickness H1 of the light blocking layer 101 can be greater than the thickness H8 of the anti-reflective layer 108.

In some embodiments, the plurality of light blocking layers 101 can absorb 90% or more visible light. In some embodiments, the light locking layers 101 can include a blackbody material. In some embodiments, the light blocking layers 101 include a layer of a single material. In some embodiments, the light blocking layers 101 include a composite layer formed of a plurality of materials. In some embodiments, the light blocking layers 101 include an organic material. In some embodiments, the light blocking layers 101 include an inorganic material.

The cover layer 102 is formed over the substrate 100 and covers the plurality of light blocking layers 101. The cover layer 102 is in contact with an upper surface 101s1 of the light blocking layers 101. The cover layer 102 is in contact with two side surfaces 101s3 and 101s4 of the light blocking layers 101. The cover layer 102 covers the upper surface 101s1 and the two side surfaces 101s3 and 101s4 of the light blocking layers 101. The cover layer 102 is formed in gaps among the plurality of light blocking layers 101. A thickness H2 of the cover layer 102 can be smaller than the thickness H0 of the substrate 100. The thickness H2 of the cover layer 102 can be substantially equal to the thickness H0 of the substrate 100. The thickness H2 of the cover layer 102 can be greater than the thickness H0 of the substrate 100. The thickness H2 of the cover layer 102 can also be greater than the thickness H1 of the light blocking layers 101. The thickness H2 of the cover layer 102 can be greater than the thickness H8 of the anti-reflective layer 108.

The plurality of first electrodes 104 are formed over the cover layer 102. The plurality of first electrodes 104 are in contact with an upper surface 102s1 of the cover layer 102. The plurality of first electrodes 104 are separated from one another. The plurality of first electrodes 104 are in direct contact with the cover layer 102. The plurality of first electrodes 104 are electrically connected to the substrate 100.

The plurality of protrusions 105 are formed on a portion of an upper surface of the first electrode 104. A peripheral region of the first electrode 104 is covered by the protrusion 105. In some embodiments, edges and corners of the first electrode 104 are completely surrounded by the protrusion 105. In some embodiments, a sidewall of the first electrode 104 is completely in contact with the protrusion 105. In some embodiments, two protrusions 105 in the gap between two first electrodes 104 are separated from each other. The light blocking layers 101 are electrically insulated from the first electrodes 104 disposed on the cover layer 102 via the cover layer 102.

In some embodiments, a thickness H4 of the first electrode 104 is smaller than the thickness H1 of the light blocking layer 101. The thickness H4 of the first electrode 104 can be substantially equal to the thickness H1 of the light blocking layer 101. The thickness H4 of the first electrode 104 can be greater than the thickness H1 of the light blocking layer 101. In some embodiments, the thickness H4 of the first electrode 104 is smaller than the thickness H8 of the anti-reflective layer 108. The thickness H4 of the first electrode 104 can be substantially equal to the thickness H8 of the anti-reflective layer 108. The thickness H4 of the first electrode 104 can be greater than the thickness H8 of the anti-reflective layer 108.

The first electrode 104 can have a total thickness of between about 1500 Å and about 2700 Å. In some embodiments, the first electrode 104 can have a total thickness of between about 1800 Å and about 2200 Å. In some embodiments, the first electrode 104 has a total thickness of about 2000 Å. The first electrode 104 can be a conductive layer. The first electrode 104 can include ITO, IZO, IGZO, an AlCu alloy, a AgMo alloy, ITO (or IZO or IGZO) of between about 50 Å and 500 Å and a metal film (Ag, Al, Mg or Au) of between about 500 Å and 2000 Å, and ITO (or IZO or IGZO) of between about 50 Å and 1000 Å.

In some embodiments, the first electrode 104 is of a composite structure. For example, the first electrode 104 includes a conductive film and a transparent conductive film located thereon. The conductive film is located between the transparent conductive film and the substrate 100. In some embodiments, the conductive film includes Al, Au, Ag and Cu. In some embodiments, the transparent conductive film includes In, Sn, graphite, Zn and O. In some embodiments, the first electrode 104 includes a transparent conductive film. In some embodiments, the first electrode 104 includes indium tin oxide (ITO). In some embodiments, the first electrode 104 includes indium zinc oxide (IZO). In some embodiments, the first electrode 104 includes indium gallium zinc oxide (IGZO). In some embodiments, a roughness Ra of the transparent conductive film is smaller than 10 Å. A thickness of the conductive film can be between about 1500 Å and about 3000 Å. The thickness of the transparent conductive film can be between about 80 Å and about 1000 Å.

In some embodiments, the first electrode 104 has at least three different films. The conductive film (for example, Al, Cu, Ag or Au) is sandwiched between two transparent conductive films. In some cases, one of the two transparent conductive films is ITO, and has one side in contact with the substrate 100 and the other side in contact with the conductive film. In some cases, one of the two transparent conductive films is ITO, and has one side in contact with the conductive film and the other side in contact with the protrusion 105 or a light emitting material.

In some embodiments, each protrusion 105 has a curved surface, which protrudes away from the substrate 100 and covers an outer peripheral region of the first electrode 104. The protrusions 105 can be in different shapes. In some embodiments, the protrusion 105 has a curved surface. In some embodiments, the protrusion 105 has a trapezoidal shape. In some embodiments, the protrusion 105 has a rectangular shape. The pattern of the protrusion 105 is designed according to a pixel arrangement, and a patterned protrusion 105 can be referred to as a pixel defined layer (PDL). The protrusions 105 are disposed on the substrate 100. Each protrusion 105 fills into a gap between two adjacent first electrodes 104. Each first electrode 104 is partially covered by the protrusion 105. The protrusion 105 can include a photosensitive material. In FIG. 3, an area of the light blocking layers 101 in a horizontal direction is greater than an area of each of the protrusions 105.

The protrusion 105 has an edge on the upper surface covering the first electrode 104. The light blocking layer 101 has an edge near a center of the first electrode 104. The edge of the light blocking layer 101 is unaligned with the edge of the protrusion 105. The edge of the protrusion 105 and the edge of the light blocking layer have an offset in between. The percentage of the offset to a width of the light blocking layer 101 can be greater than or equal to 10%. The percentage of the offset to the width of the light blocking layer 101 can be greater than or equal to 20%. The percentage of the offset to the width of the light blocking layer 101 can be greater than or equal to 30%. The percentage of the offset to the width of the light blocking layer 101 can be greater than or equal to 40%.

In some embodiments, the spacer 21 in FIG. 2 includes the plurality of protrusions 105 so as to define a light emitting pixel pattern. The recess is located between two adjacent protrusions 105 and provides a space for accommodating light emitting pixels. When viewing from the cross-sectional diagram, a person skilled in the art would be able to understand that the protrusions 105 are depicted in a disconnected manner. However, when viewing from the schematic plan view of FIG. 2, the protrusions 105 can be connected to one another by other parts of the spacer 21.

The light emitting element 30 includes a light emitting array, which includes a first organic light emitting unit 30a, a second organic light emitting unit 30b and a third organic light emitting unit 30c. The organic light emitting unit in the present application can also be referred to as a light emitting pixel. In some embodiments, the light emitting unit 30a includes a first electrode 104, a carrier injection layer 106L1 over the protrusion 105 and the first electrode 104, a carrier transport layer 106L2 over the carrier injection layer 106L1, an organic emissive layer 106L3 over a portion of the carrier transport layer 106L2, and an organic carrier transport layer 106L4 over the organic emissive layer 106L3. The carrier injection layer 106L1, the carrier transport layer 106L2, the organic emissive layer 106L3 and the organic carrier transport layer 106L4 can be collectively referred to as the organic light emitting stack layer 106.

In some embodiments, the carrier injection layer 106L1 is disposed between the first electrode 104 and the carrier transport layer 106L2. The light emitting unit 30a includes an organic material, which can be disposed in any one of the carrier transport layer, the carrier injection layer and the organic emissive layer in the light emitting unit 30a according to different embodiments. Moreover, the organic material has an absorption rate of greater than or equal to 50% for a predetermined wavelength in some embodiments, an absorption rate of greater than or equal to 60% for a predetermined wavelength in some embodiments, an absorption rate of greater than or equal to 70% for a predetermined wavelength in some embodiments, an absorption rate of greater than or equal to 80% for a predetermined wavelength in some embodiments, an absorption rate of greater than or equal to 90% for a predetermined wavelength in some embodiments, or an absorption rate of greater than or equal to 95% for a predetermined wavelength in some embodiments. In some embodiments, the predetermined wavelength is not greater than 400 nm, not greater than 350 nm in some embodiments, not greater than 300 nm in some embodiments, not greater than 250 nm in some embodiments, not greater than 200 nm in some embodiments, not greater than 150 nm in some embodiments, or not greater than 100 nm in some embodiments.

In FIG. 3, the distance between the plurality of light blocking layers 101 is W1, and a distance between two adjacent protrusions 105 is W2. In some embodiments, the distance W2 between two adjacent protrusions 105 is greater than the distance W1 between the plurality of light blocking layers 101. In some embodiments, the distance W2 between two adjacent protrusions 105 can define an area of an effective light emitting region. Since the distance W1 between the plurality of light blocking layers 101 is smaller than W2, the plurality of light blocking layers 101 can control light emitted by the first electrodes 104 to thereby improve an imaging effect of a pattern.

Moreover, because the light blocking layer 101 can block ambient light traveling upward from the substrate 100, optical crosstalk between the ambient light and the light emitted by the light emitting unit 30a can be reduced. Alternatively speaking, because the light blocking layer 101 can absorb 90% or more of the ambient light traveling upward from the substrate 100, optical crosstalk between the ambient light and the light emitted by the light emitting unit 30a can be thus reduced.

In some embodiments, the protrusion 105 has an absorption rate of greater than or equal to 50% for a predetermined wavelength, an absorption rate of greater than or equal to 60% for a predetermined wavelength in some embodiments, an absorption rate of greater than or equal to 70% for a predetermined wavelength in some embodiments, an absorption rate of greater than or equal to 80% for a predetermined wavelength in some embodiments, an absorption rate of greater than or equal to 90% for a predetermined wavelength in some embodiments, or an absorption rate of greater than or equal to 95% for a predetermined wavelength in some embodiments. In some embodiments, the predetermined wavelength is not greater than 400 nm, not greater than 350 nm in some embodiments, not greater than 300 nm in some embodiments, not greater than 250 nm in some embodiments, not greater than 200 nm in some embodiments, not greater than 150 nm in some embodiments, or not greater than 100 nm in some embodiments.

The carrier injection layer 106L1 is disposed on the cover layer 102, the protrusion 105 and an exposed surface of the first electrode 104. The carrier injection layer 106L1 continuously covers the protrusion 105 and the exposed surface of the first electrode 104. In some embodiments, the exposed surface of each first electrode 104 is an effective light emitting region configured to be used for one light emitting unit 30a. Optionally, the carrier injection layer 106L1 is in contact with the protrusion 105. In some embodiments, the carrier injection layer 106L1 is in contact with the first electrode 104. In some embodiments, the carrier injection layer 106L1 is an organic body. In some embodiments, the carrier injection layer 106L1 is configured to perform hole injection. In some embodiments, the carrier injection layer 106L1 is a hole injection layer. In some embodiments, the carrier injection layer 106L1 can have a thickness of between about 80 Å and about 500 Å.

The carrier transport layer 106L2 is disposed on the cover layer 102, the protrusion 105 and the exposed surface of the first electrode 104. The carrier transport layer 106L2 is disposed over the carrier injection layer 106L1 and completely covers the carrier injection layer 106L1. The carrier injection layer 106L1 is disposed below the carrier transport layer 106L2. The carrier transport layer 106L2 continuously covers the carrier injection layer 106L1. The carrier transport layer 106L2 covers the plurality of protrusions 105 and the plurality of first electrodes 104. Optionally, the carrier transport layer 106L2 is in contact with the carrier injection layer 106L1. In some embodiments, the carrier transport layer 106L2 is an organic body. In some embodiments, the carrier transport layer 106L2 is configured to perform hole transport. In some embodiments, the carrier transport layer 106L2 is a first hole transport layer. In some embodiments, the carrier injection layer 106L1 can have a thickness of between about 80 Å and about 500 Å.

The organic emissive layer 106L3 is disposed on the cover layer 102, the protrusion 105 and the exposed surface of the first electrode 104. The organic emissive layer 106L3 is disposed over the carrier transport layer 106L2 and completely covers the carrier transport layer 106L2. The carrier transport layer 106L2 is disposed below the organic emissive layer 106L3. The organic emissive layer 106L3 continuously covers the carrier transport layer 106L2. The organic emissive layer 106L3 covers the plurality of protrusions 105 and the plurality of first electrodes 104. Optionally, the organic emissive layer 106L3 is in contact with the carrier transport layer 106L2. The organic emissive layer 106L3 is configured to emit a first color.

The organic emissive layer 106L3 has an absorption rate of greater than or equal to 50% for a predetermined wavelength in some embodiments, an absorption rate of greater than or equal to 60% for a predetermined wavelength in some embodiments, an absorption rate of greater than or equal to 70% for a predetermined wavelength in some embodiments, an absorption rate of greater than or equal to 80% for a predetermined wavelength in some embodiments, an absorption rate of greater than or equal to 90% for a predetermined wavelength in some embodiments, or an absorption rate of greater than or equal to 95% for a predetermined wavelength in some embodiments. In some embodiments, the predetermined wavelength is not greater than 400 nm, not greater than 350 nm in some embodiments, not greater than 300 nm in some embodiments, not greater than 250 nm in some embodiments, not greater than 200 nm in some embodiments, not greater than 150 nm in some embodiments, or not greater than 100 nm in some embodiments.

In some embodiments, at least one of the carrier transport layer 106L2 and the organic emissive layer 106L3 includes an organic material. The organic material can include a molecular structure having a resonance structure. The organic material can be selected from a group consisting of spiro-triarylamine, bis-triarylamine and a combination thereof. In some embodiments, at least one of the carrier transport layer 106L2 and the organic emissive layer 106L3 includes spiro-triarylamine. In some embodiments, at least one of the carrier transport layer 106L2 and the organic emissive layer 106L3 includes bis-triarylamine.

The organic carrier transport layer 106L4 is disposed on the cover layer 102, the protrusion 105 and the exposed surface of the first electrode 104. The organic carrier transport layer 106L4 is disposed over the organic emissive layer 106L3 and completely covers the organic emissive layer 106L3. The organic emissive layer 106L3 is disposed below the organic carrier transport layer 106L4. The organic carrier transport layer 106L4 continuously covers the organic emissive layer 106L3. The organic carrier transport layer 106L4 covers the plurality of protrusions 105 and the plurality of first electrodes 104. Optionally, the organic carrier transport layer 106L4 is in contact with the organic emissive layer 106L3.

The second electrode 106D is disposed on the cover layer 102, the protrusion 105 and the exposed surface of the first electrode 104. The second electrode 106D is located over the organic carrier transport layer 106L4 and completely covers the organic carrier transport layer 106L4. In some cases, the second electrode 106D is patterned to cover only the effective light emitting region of each light emitting pixel. In some cases, the second electrode 106D is in contact with the organic carrier transport layer 106L4.

The second electrode 106D can have a thickness of between about 80 Å and about 500 Å. In some embodiments, the second electrode 106D can have a thickness of between about 80 Å and about 150 Å. In some embodiments, the second electrode 106D can have a thickness of between about 150 Å and about 200 Å. In some embodiments, the second electrode 106D can have a thickness of between about 200 Å and about 300 Å. In some embodiments, the second electrode 106D can have a thickness of between about 300 Å and about 400 Å. In some embodiments, the second electrode 106D can have a thickness of between about 400 Å and about 500 Å.

In some embodiments, the second electrode 106D can be a cathode. The second electrode 106D can be a metal material, for example, Ag or Mg. In some embodiments, the second electrode 106D includes ITO or IZO. In some embodiments, the second electrode 106D is of a composite structure. For example, the second electrode 106D includes a conductive film and a transparent conductive film located thereon. The conductive film is located between the transparent conductive film and the organic carrier transport layer 106L4. In some embodiments, the conductive film includes Al, Au, Ag, Cu, Mg and Mo. In some embodiments, the transparent conductive film includes In, Sn, graphite, Zn and O. In some embodiments, the transparent conductive film is ITO. In some embodiments, the transparent conductive film is IZO. In some embodiments, the transparent conductive film is located between the conductive film and the organic carrier transport layer 106L4.

In FIG. 3, the light emitting element 30 includes the substrate 100, the plurality of protrusions 105 on the substrate 100, and the plurality of light emitting units separated by the protrusions 105.

These light emitting units include the first light emitting unit 30a, the second light emitting unit 30b and the third light emitting unit 30c. In some embodiments, the first light emitting unit 30a, the second light emitting unit 30b and the third light emitting unit 30c are adjacent to one another. In some embodiments, the second light emitting unit 30b and the third light emitting unit 30c have structures similar to the first light emitting unit 30a. Moreover, although the first light emitting unit 30a, the second light emitting unit 30b and the third light emitting unit 30c are depicted to have similar characteristics, such is merely an example and is not intended to form limitations to the embodiments. The first light emitting unit 30a, the second light emitting unit 30b and the third light emitting unit 30c can have similar or different structures to satisfy desired functional requirements.

The first light emitting unit 30a, the second light emitting unit 30b and the third light emitting unit 30c can be different from one another at least in terms of the thickness of the organic light emitting stack layer. In some embodiments, the first light emitting unit 30a emits green light, the second light emitting unit 30b emits red light and the third light emitting unit 30c emits blue light.

In some embodiments, the light emitting units 30a, 30b and 30c are configured to be divided into at least three different groups, wherein each group emits a color different from colors emitted by the other groups. The thickness of each organic light emitting stack layer can be associated with the colors displayed by the corresponding light emitting units 30a, 30b and 30c. In some embodiments, in comparison with the other light emitting units configured to emit different colors, the first light emitting unit 30a emits green light, and the organic light emitting stack layer of the first light emitting unit 30a can have the smallest thickness. In some embodiments, in comparison with the other light emitting units configured to emit different colors, the second light emitting unit 30b emits red light, and a thickness of the organic light emitting stack layer of the second light emitting unit 30b can be between the thickness of the organic light emitting stack layer of the first light emitting unit 30a and a thickness of the organic light emitting stack layer of the third light emitting unit 30c. In some embodiments, in comparison with the other light emitting units configured to emit different colors, the third light emitting unit 30c emits blue light, and the organic light emitting stack layer of the third light emitting unit 30c can have the largest thickness. The organic light emitting stack layers of the first light emitting unit 30a, the second light emitting unit 30b and the third light emitting unit 30c can be formed by various processes such as vapor deposition, liquid spray or inkjet printing.

In some embodiments, the first, second and third light emitting units 30a, 30b and 30c can be different from one another at least in thickness differences of the carrier transport layers of the first, second and third light emitting units 30a, 30b and 30c.

In some embodiments, the light emitting units 30a, 30b and 30c are configured to be divided into at least three different groups, wherein each group emits a color different from colors emitted by the other groups. The thickness of the carrier transport layer can be associated with the color displayed by the corresponding light emitting unit 30a. In some embodiments, in comparison with the other light emitting units configured to emit different colors, the first light emitting unit 30a emits green light, and the carrier transport layer of the first light emitting unit 30a can have the smallest thickness. In some embodiments, in comparison with the other light emitting units configured to emit different colors, the second light emitting unit 30b emits red light, and a thickness of the carrier transport layer of the second light emitting unit 30b can be between the thickness of the carrier transport layer of the first light emitting unit 30a and a thickness of the carrier transport layer of the third light emitting unit 30c. In some embodiments, in comparison with the other light emitting units configured to emit different colors, the third light emitting unit 30c emits blue light, and the carrier transport layer of the third light emitting unit 30c can have the largest thickness.

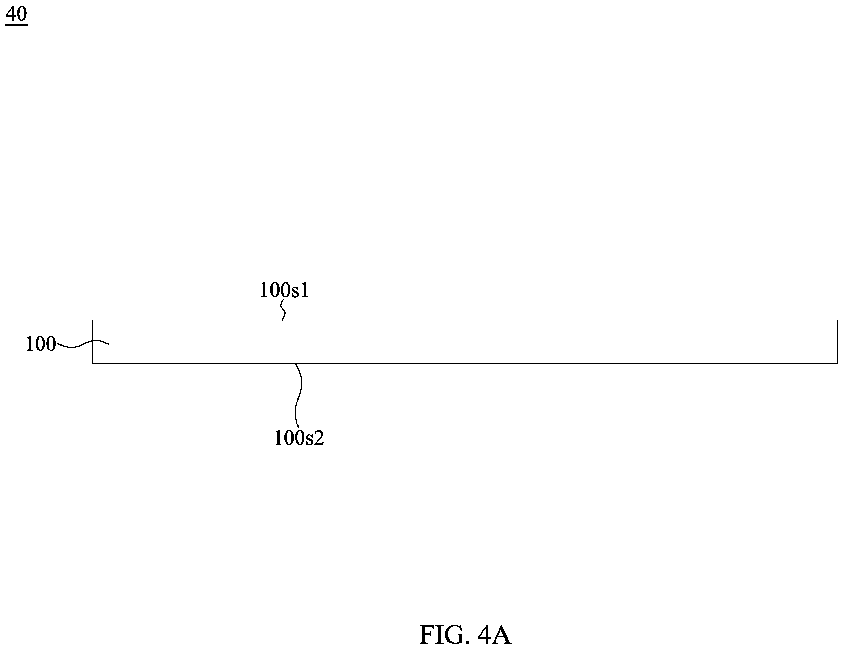

FIG. 4A to FIG. 4G depict different stages of a process for manufacturing a light emitting element 40 according to an embodiment. In FIG. 4A, the substrate 100 is provided, the substrate 100 having the upper surface 100s1 and the lower surface 100s2.

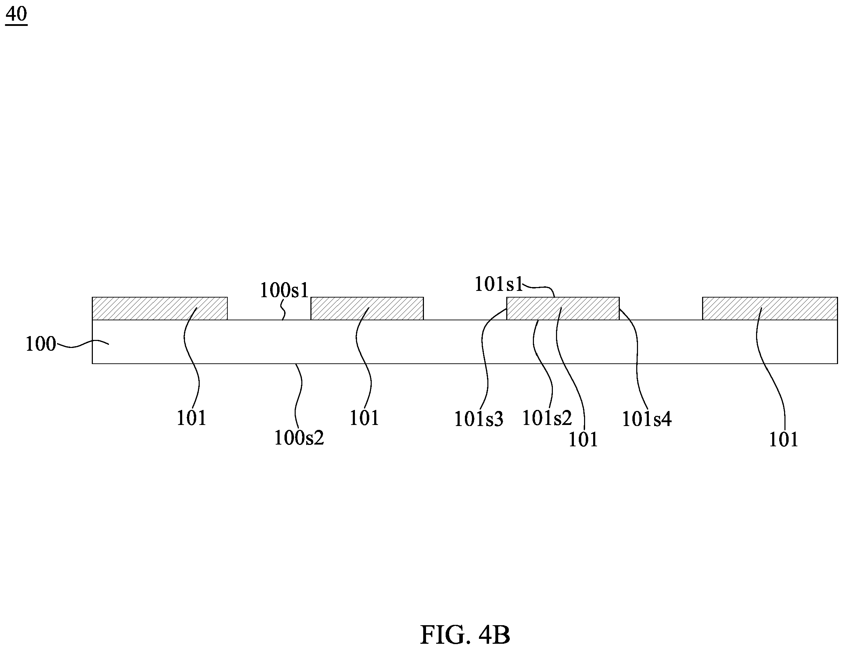

In FIG. 4B, the plurality of light blocking layers 101 are disposed on the substrate 100. Each of the light blocking layers 101 is configured on the same side of the substrate 100. The plurality of light blocking layers 101 are each in contact with the upper surface 100s1 of the substrate 100. The light blocking layers 101 are separated from one another. The lower surface 101s2 of the light blocking layer 101 is in direct contact with the upper surface 100s1 of the substrate 100.

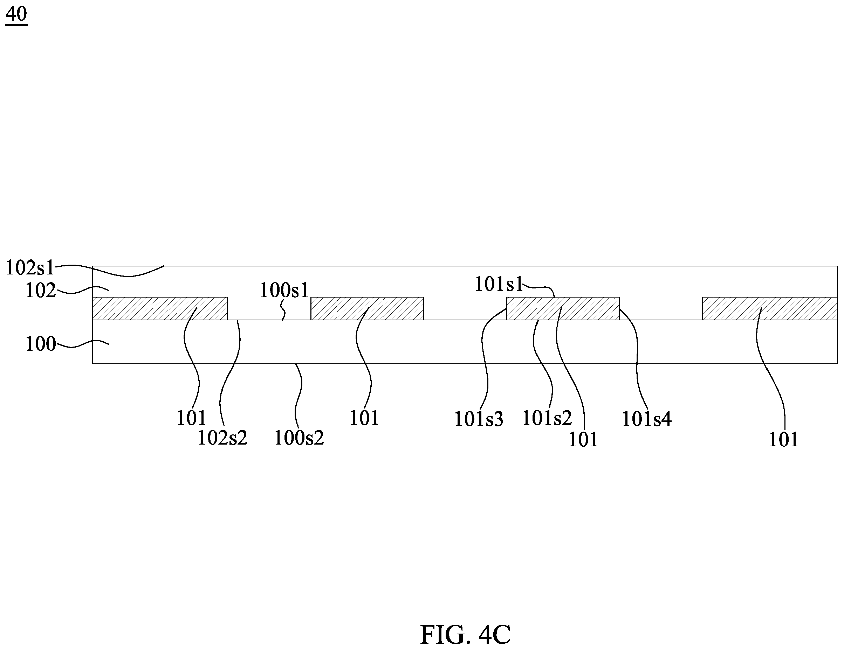

In FIG. 4C, the cover layer 102 is disposed on each of the light blocking layers 101. The cover layer 102 surrounds the upper surface 101s1 and the two side surfaces 101s3 and 101s4 of each of the plurality of light blocking layers 101. The cover layer 102 is in contact with the substrate 100. The cover layer 102 is formed over the plurality of light blocking layers 101 by one of chemical vapor deposition (CVD), physical vapor deposition (PVD) and spin on glass (SOG).

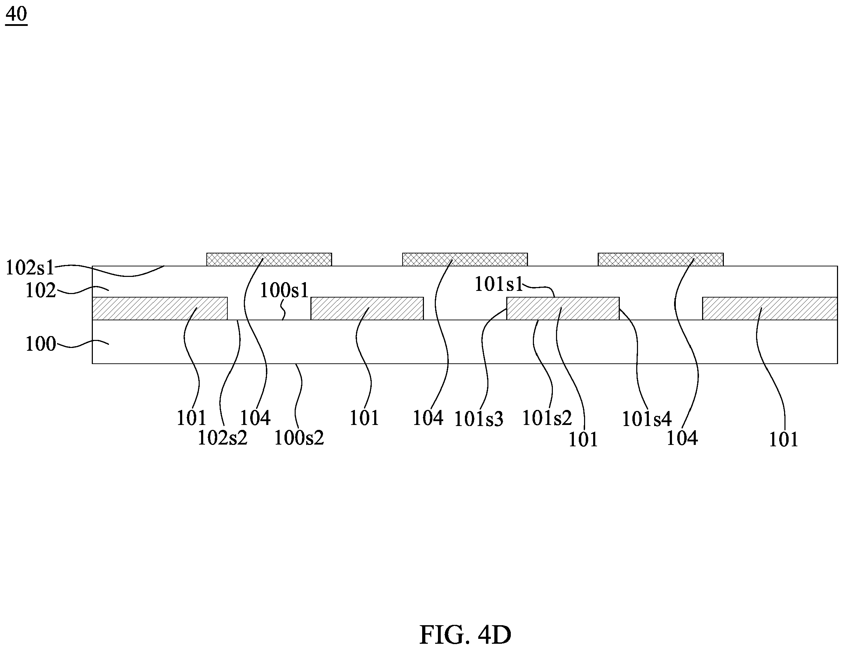

In FIG. 4D, the plurality of first electrodes 104 are disposed on the cover layer 102. Each of the first electrodes 104 is configured to be electrically connected to the substrate 100. The plurality of first electrodes 104 are each in direct contact with the upper surface 102s1 of the cover layer 102. An array pattern of the first electrodes 104 is designed in consideration of an arrangement of pixels.

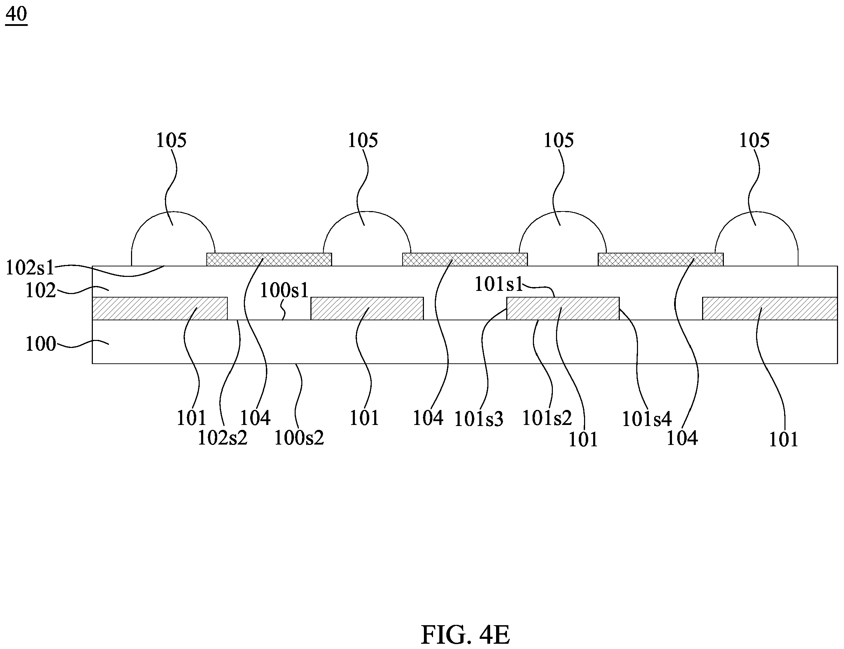

In FIG. 4E, the plurality of protrusions 105 are disposed on the cover layer 102. Each of the protrusions 105 is formed on a portion of an upper surface of the first electrode 104 and envelops a side surface of the first electrode 104. The protrusion 105 partially covers each of the first electrodes 104. The protrusions 105 can be formed to have different shapes. In some embodiments, the protrusion 105 has a curved surface. In some embodiments, the protrusion 105 has a trapezoidal shape. After the protrusion 105 is formed, a cleaning operation is performed to clean the protrusion 105 and the exposed surface of the first electrode 104. In some embodiments, during the cleaning operation, deionized water is heated to a temperature between 30°C and 80°C. Once the temperature of the deionized water rises to a predetermined temperature, the deionized water is guided to the protrusion 105 and the exposed surface of the first electrode 104.

In some embodiments, ultrasonic waves are used during the cleaning operation. Ultrasonic waves are introduced into a cleaning agent (for example, water or isopropyl alcohol (IPA). In some embodiments, carbon dioxide is introduced into the cleaning agent. After the cleaning operation, the cleaning agent is removed from the exposed surface by a heating operation. During the heating operation, the substrate 100 and the protrusion 105 can be heated to a temperature between 80°C and 110°C. In some examples, compressed air is guided to the exposed surface, so as to facilitate removing residuals of the cleaning agent while heating. After the heating operation, O₂, N₂ or Ar plasma can be used to process the exposed surface. The plasma is used to roughen the exposed surface. In some embodiments, ozone is used to adjust conditions of the exposed surface.

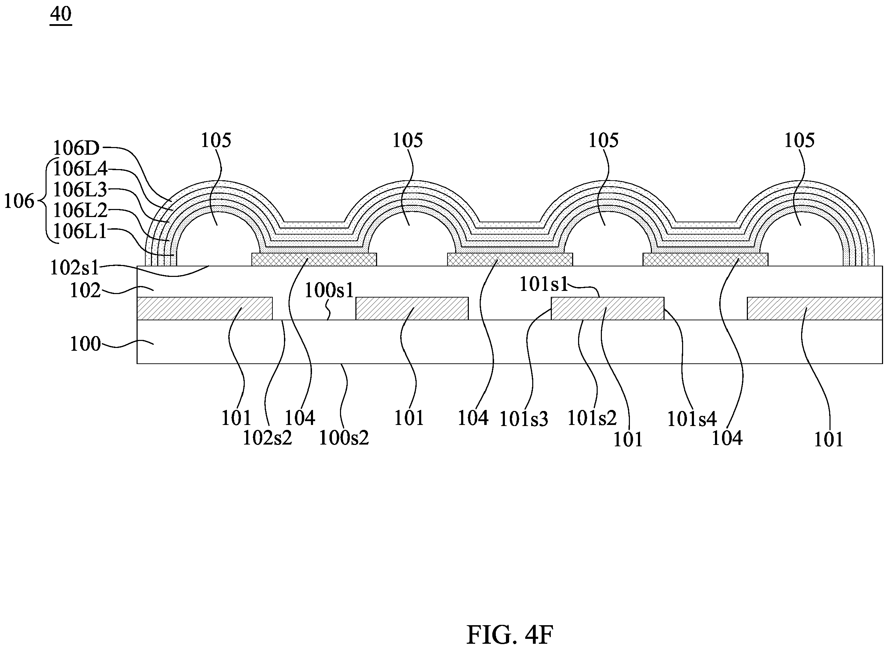

As shown in FIG. 4F, the carrier injection layer 106L1 is disposed on the protrusion 105, a portion of an exposed surface of the cover layer 102, and the exposed surface of the first electrode 104. The carrier injection layer 106L1 lines continuously along the exposed surface. More specifically, the exposed surface of each of the first electrodes 104 is configured to serve as an effective light emitting area of a light emitting unit (that is, a pixel). In this embodiment, all of the light emitting units use the carrier injection layer 106L1. In some embodiments, the carrier injection layer 106L1 is used for hole injection. In some embodiments, the carrier injection layer 106L1 is used for electron injection. The carrier injection layer 106L1 continuously covers the plurality of protrusions 105 and the exposed surface of the first electrode 104. Optionally, the carrier injection layer 106L1 is in contact with the protrusion 105. In some embodiments, the carrier injection layer 106L1 is in contact with the first electrode 104. In some embodiments, the carrier injection layer 106L1 is organic.

The carrier transport layer 106L2 is disposed on the protrusion 105, a portion of an exposed surface of the cover layer 102, and the exposed surface of the first electrode 104. The carrier injection layer 106L1 is disposed below the carrier transport layer 106L2. The carrier transport layer 106L2 lines continuously along the carrier injection layer 106L1. In this embodiment, all of the light emitting units use the carrier transport layer 106L2. In some embodiments, the carrier transport layer 106L2 is used for hole injection. In some embodiments, the carrier transport layer 106L2 is used for electron injection. The carrier transport layer 106L2 continuously covers over the plurality of protrusions 105 and the first electrodes 104. Optionally, the carrier transport layer 106L2 is in contact with the carrier injection layer 106L1. In some embodiments, the carrier transport layer 106L2 is organic. The organic emissive layer 106L3 is disposed on the protrusion 105, a portion of the exposed surface of the cover layer 102, and the exposed surface of the first electrode 104. The organic emissive layer 106L3 covers the carrier transport layer 106L2. The organic emissive layer 106L3 completely covers the exposed carrier transport layer 106L2. The organic emissive layer 106L3 is configured to emit a first color.

As shown in FIG. 4F, the organic carrier transport layer 106L4 is disposed on the organic emissive layer 106L3. The organic carrier transport layer 106L4 can be a hole or electron transport layer. In some embodiments, the organic carrier transport layer 106L4 and the carrier transport layer 160L2 are each configured in opposite valence states. In some embodiments, the second electrode 106D is disposed on the organic carrier transport layer 106L4. The second electrode 160D covers the organic carrier transport layer 106L4. The second electrode 106D can be a metal material, for example, Ag or Mg. In some embodiments, the second electrode 106D includes ITO or IZO. In some embodiments, when observing from a cross-sectional diagram, each of the light emitting units (that is, each pixel) has a separate second electrode 106D.

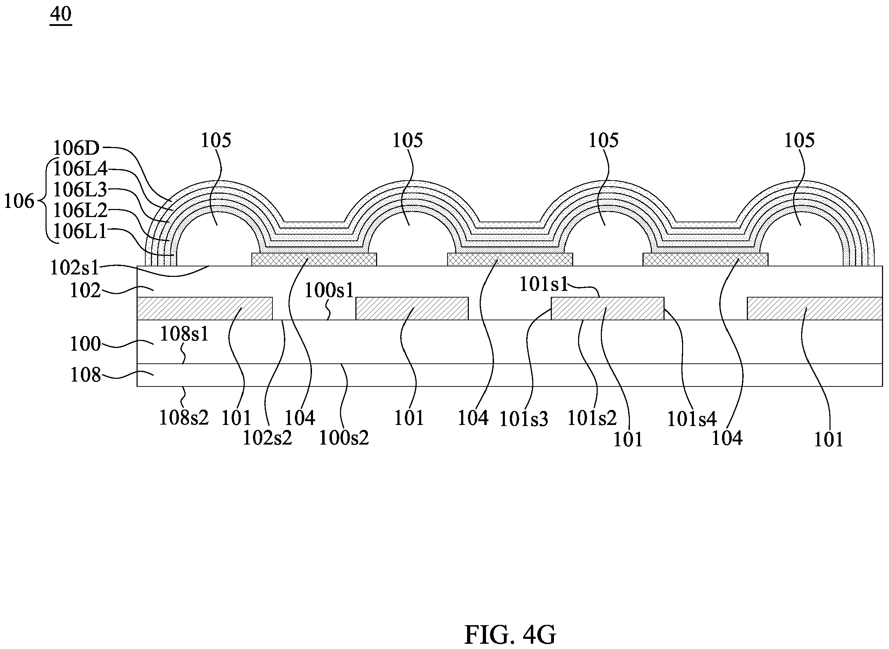

In FIG. 4G, the anti-reflective layer 108 is disposed on the lower surface 100s2 of the substrate 100. The upper surface 108s1 of the anti-reflective layer 108 is in contact with the lower surface 100s2 of the substrate 100. The anti-reflective layer 108 can include, for example but not limited to, calcium fluoride, magnesium fluoride, titanium oxide, lead sulfide, lead selenide, a vinyl silsesquioxane hybrid film, or a diamond film. In some embodiment, the anti-reflective layer 108 is plated on the lower surface 100s2 of the substrate 100. In some embodiments, the anti-reflective layer 108 can be formed by sputtering, chemical plating, evaporation or electroplating.

The operations shown in FIG. 4A to FIG. 4G can be repeatedly performed so as to form light emitting units of different colors.

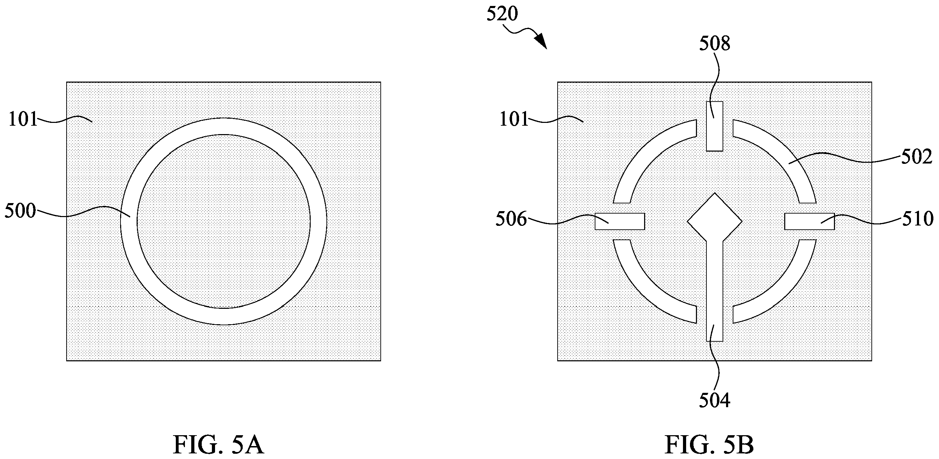

Referring to FIG. 5A, in some embodiments, the light blocking layer 101 can have a recess 500 (which can correspond to the part W1 shown in FIG. 3) exhibiting an arc profile from a perspective of a plan view. The recess 500 can also be referred to as an opening. The recess 500 allows transmission of light emitted by a light emitting unit (for example, 30a, 30b or 30c). In some embodiments, the recess 500 allows transmission of light emitted by one single light emitting unit. In some embodiments, the recess 500 allows transmission of light emitted by a plurality of light emitting units. Referring to FIG. 5B, in some embodiments, the light blocking layer 101 can include a first recess 502 and second recesses 504, 506, 508 and 510. The first recess 502 has an arc profile. The second recess 504 has an arrow-shaped profile. The second recesses 506, 508 and 510 have rectangular profiles. The first recess 502 and the second recesses 504, 506, 508 and 510 are in a staggered arrangement so as to jointly form a bullseye pattern (for example, the pattern 120 shown in FIG. 1).

The bullseye pattern allows transmission of light emitted by a light emitting unit (for example, 30a, 30b or 30c). In some embodiments, the first recess 502 can overlap an effective light emitting area of a single light emitting unit, so as to allow transmission of light emitted by the single light emitting unit. In some embodiments, the first recess 502 can overlap effective light emitting areas of a plurality of light emitting units, so as to allow transmission of light emitted by the plurality of light emitting units. In some embodiments, each of the second recesses 504, 506, 508 and 510 can overlap an effective light emitting area of a single light emitting unit, so as to each allow transmission of light emitted by the single light emitting unit. In some embodiments, each of the second recesses 504, 506, 508 and 510 can overlap effective light emitting areas of a plurality of light emitting units, so as to each allow transmission of light emitted by the plurality of light emitting units.

In some embodiments, the first recess 502 and the second recesses 504, 506, 508 and 510 can overlap an effective light emitting area of a single light emitting unit, so as to allow transmission of light emitted by the single light emitting unit. In some embodiments, the first recess 502 and the second recesses 504, 506, 508 and 510 can overlap effective light emitting areas of a plurality of light emitting units, so as to allow transmission of light emitted by the plurality of light emitting units.

The present application can adjust the pattern into a desired shape according to actual requirements.

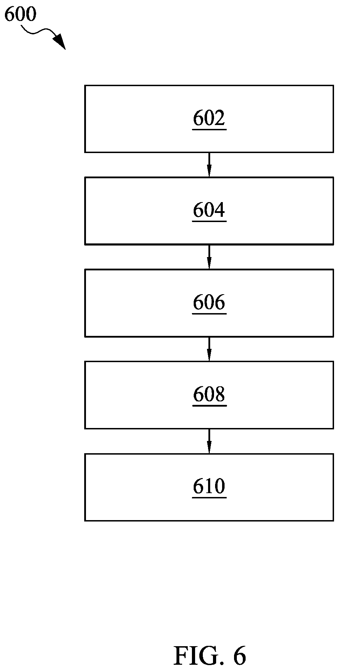

FIG. 6 shows a flowchart 600 of manufacturing of a light emitting element according to an embodiment. In step 602, the plurality of light blocking layers 101 are disposed on the substrate 100 and a plurality of openings are included. In step 604, the cover layer 102 is applied so as to cover the plurality of light blocking layers 101. In step 606, the first electrode 104 is plated on the upper surface of the cover layer 102. In step 608, the plurality of protrusions 105 and the organic light emitting stack layer 106 are formed. In step 610, the anti-reflective layer 108 is plated on the lower surface of the substrate 100.

The features of some embodiments are summarized in the description above for a person skilled in the art to better understand various aspects of the present disclosure. A person skilled in the art would be able to understand that the present disclosure can be used as the basis for designing or modifying other manufacturing processes and structures so as to achieve the same objects and/or the same advantages of the embodiments described in the present application. A person skilled in the art would also be able to understand that such structures do not depart from the spirit and scope of the disclosure of the present application, and various changes, substitutions and replacements may be made by a person skilled in the art without departing from the spirit and scope of the present disclosure.

## Claims

1. A light emitting element (30), comprising:
a substrate (100);
a plurality of light blocking layers (101), disposed on a first surface (100s1) of the substrate and comprising a plurality of openings;
a cover layer (102), being in contact with first surfaces (101sl) of the plurality of light blocking layers and covering the plurality of light blocking layers;
a plurality of protrusions (105), disposed on the cover layer, wherein two adjacent protrusions of the plurality of protrusions have an organic light emitting unit (30a, 30b, 30c) in between; and
an anti-reflective layer (108), disposed on a second surface (100s2) of the substrate, wherein the second surface is parallel to and opposite to the first surface.

2. The light emitting element according to claim 1, wherein an average reflectance of the anti-reflective layer is smaller than a first value, a reflectance of the anti-reflective layer with respect to a predetermined wavelength is smaller than a second value, and the first value is smaller than the second value.

3. The light emitting element according to claim 2, wherein the predetermined wavelength comprises a wavelength of visible light.

4. The light emitting element according to any of claims 1-3, wherein the organic light emitting unit comprises a first light emitting unit (30a) and a second light emitting unit (30b), wherein each of the first light emitting unit and the second light emitting unit has an organic light emitting stack layer (106) comprising an organic material.

5. The light emitting element according to claim 4, wherein each of the first light emitting unit and the second light emitting unit has an effective light emitting region with a size defined by an anode (104) located below each of the light emitting units.

6. The light emitting element according to claim 1, wherein the light blocking layers are electrically insulated from a conductive layer (104) disposed on the cover layer via the cover layer.

7. The light emitting element according to any of claims 1-6, wherein the substrate comprises a transparent material.

8. The light emitting element according to any of claims 1-7, wherein an edge of one of the plurality of openings of the light blocking layers is unaligned with an edge of one of the plurality of protrusions.

9. The light emitting element according to claim 2, wherein the first value is smaller than 0.6%, and the second value is smaller than 1%.

10. The light emitting element according to claim 1, wherein in a vertical direction, each of the plurality of protrusions has an edge, which is offset from an edge of one of the plurality of light blocking layers.

11. The light emitting element according to claim 10, wherein in a horizontal direction, an area of each of the plurality of light blocking layers is greater than an area of each of the plurality of protrusions.
